# EUROPEAN PATENT SPECIFICATION

(11) **EP 0 600 534 B1**
(45) Date of publication and mention of the grant of the patent: **29.03.2000**
(21) Application number: 93203251.9
(22) Date of filing: 19.11.1993
(51) Int. Cl.: G03F 3/10, B32B 27/00, G03C 11/08

(54) **Process and materials for controlling the visual aspect of images**
Verfahren und Materialien zur Kontrolle des visuellen Aspektes von Bildern
Procédé et matériaux pour contrôler l'aspect visuel des images

(30) Priority: 01.12.1992 EP 92203713
(43) Date of publication of application: 08.06.1994
(73) Proprietor: AGFA-GEVAERT N.V., 2640 Mortsel (BE)
(72) Inventor: Leenders, Luc, B-2640 Mortsel (BE); Daems, Eddie, B-2640 Mortsel (BE)

(56) References cited:
- EP-A- 0 242 655
- EP-A- 0 324 192
- EP-A- 0 348 310
- EP-A- 0 462 330
- EP-A- 0 487 790
- DE-A- 1 422 940
- FR-A- 1 537 959
- US-A- 3 178 287
- RESEARCH DISCLOSURE no. 241 , May 1984 , HAVANT GB pages 189 - 193 AN. 'Aqueous copolyester dispersions suited for the subbing of polyester film'

## Description

The present invention relates to a process and materials for controlling the visual aspect of images present in hydrophilic colloid layer(s) or relief pattern(s).

The visual aspect of images obtained in hydrophilic colloid media such as in a developed and fixed gelatin silver halide emulsion layer is largely affected by background colour and light-reflectance of the support that carries the image layer. Photographs to be inspected in reflection usually have a polyethylene-coated paper support. The surface structure of the polyethylene-coated paper and its colour tone largely determine the visual aspect of the image e.g. its gloss. A glossy aspect adds to the contrast and gives a better rendering of fine detail. Glossy photographic paper as supplied by the manufacturer dries with a shiny surface, which can further be improved by glazing. For example, a wet print can be glazed by squeegeeing it onto a clean polished surface that optionally is heated. Hot-glazing requires the use of gelatin layers that are hardened otherwise they would melt and stick to the glazing plate.

Normally photographic silver halide emulsion materials have an outermost anti-abrasion layer. Known anti-abrasion layers usually are gelatin layers having a thickness of a few µm and optionally containing a hardening agent for gelatin e.g. chrome alum or some colloidal inorganic material such as silica as described e.g. by P. Glafkidés in "Photographic Chemistry", Vol. I, Fountain Press - London (1985) p. 474 and in FR-P 1,551,591.

The application of a thin anti-abrasion layer acting also as gloss-improving layer, by coating from a liquid composition requires a cumbersome and sophisticated coating equipment, which in practice is available only in factories producing photographic materials. In some cases it may be interesting to have the possibility to determine at the stage of image processing what kind of visual aspect a print should have. For example, such is the case when a photographic image has been formed on a permanent support by a plurality of superposed hydrophilic colloid patterns representing a multi-colour relief image obtained by wash-off processing of hardening-developed coloured hydrophilic colloid layers.

The production of colour relief images representing linework or halftone multicolour colloid patterns is of interest in the field of design, e.g. in the production of colour decorative patterns, colour wiring and circuit diagrams, cartography, colour proofing and the production of images on reflective base for overhead projection.

Photographically produced colour proofs are a substitute for multicolour halftone reproductions as will be produced by successive printing in register with the separate standard inks: magenta, yellow, cyan and black, on a conventional printing press.

Press proofing for the production of colour proofs by preparing a printing plate and running the plate on the press to produce only a few copies as proof of the quality of the halftone separation transparencies used in the plate production is a very expensive procedure and therefore photographic processes have been developed to obtain a similar result by means of which the aspect of a print obtained from particular colour separation negatives or positives can be judged by the printer and client before the expensive press printing process is started.

Examples of processes for the production of multicolour relief patterns using the transfer of coloured colloid layers from a temporary support onto a permanent support have been described in e.g. US-P 3,642,474, 4,701,401 and 4,710,444.

In such processes the multicolour pattern is formed by superposed relief patterns obtained by wash-off processing.

When said processes are used for the production of multicolour halftone images serving as pre-press colour proof, it is important that the total dot area of the screened images obtained resembles as close as possible the total dot area of the halftone prints obtained in the mechanical printing process. The optical dot area (ODA) is a measure of the total dot area that takes into account both physical and optical dot gain. The optical dot area (ODA) is the total amount of light absorbed by the halftone dot pattern printed on a substrate. It is expressed as the percentage of the substrate that would have to be covered with halftone dots to achieve a certain density, provided there was no dot spread and the substrate reflected 100 percent of the light on the surface (ref. the article "Dot Gain: Causes and Cures" - "The Quality Control Scanner" published monthly by Graphic Arts Publishing Co., 3100 Bronson Hill Road, Livonia NY 14487. (1982) Volume 2, Number 9, p. 5).

Dot gain is made up of two components, physical and optical dot gain. Physical dot gain is an enlargement of mechanical dot size which occurs during the printing process wherein individual ink dots are spread on the printing paper.

Optical dot gain results when light penetrates the printing paper in the clear areas, becomes internally scattered therein and partially absorbed in the ink dots making the dots visually appear larger. Optical dot gain can be influenced by changing the paper stock (see the article "Gaining on Dot Gain" by Johan Strashun in Graphic Arts Montly, January 1985, p. 69).

In offset printing the greatest dot gain occurs in the mid tones, i.e. around the 50 percent dot value. Good colour balance is obtained when all colours have equal dot gain.

It is known from EP-A 0,236,783 to make electrophotographic colour proofs of halftone dot patterns, which colour proofs closely simulate the dot gain of prints made with lithographic plates and inks. The resulting colour proof comprises a toner dot pattern on a reflective support and the toner pattern is covered by stripping and laminating with a thin transparent layer and a thicker transparent layer to give the screen dots in the toner pattern an apparent increase in optical dot area (ODA) which simulates that of the press print.

Ep-A- 462330 describes a process and a material as referred to in claims 1 and 7, but uses nitrocellulose instead of polyester on the tempory support, and it does not disclose the use of a poly(ethyl acrylate) adhesion promoter.

For completeness'sake reference is also made to EP-A 0,183,467, in which a resin-coated photographic base paper has been described, which comprises a paper support carrying on its face side an extruded first layer of low density polyethylene or a blend of low density and high density polyethylene containing at least 50% by weight of low density polyethylene, the first layer being coated at a ratio of 10 to 50 g/m2 and containing at least 5% of opacifying pigment, and an extruded second layer of a polymer having a stifness modulus of at least 0.5 GPa, e.g. a polycarbonate resin. This photographic base paper is merely a stiff non-strippable support, on which photographic emulsions can be coated.

It has been found now that the visual aspect of images present in hydrophilic colloid layer(s) or relief pattern(s) can be improved according to the process of claim 7 and by means of the materials of claim 1.

The process according to the present invention as defined in claim 7 for controlling the visual aspect of an image present in a hydrophilic colloid layer, layer system, or relief pattern on a permanent support is characterized by the step of transferring a continuous non-photosensitive layer assembly from a temporary support to said image, said transfer being brought about by the consecutive steps of:
1) pre-wetting the image-carrying permanent support,
2) bringing the pre-wet image-carrying permanent support in face-to-face contact with said continuous non-photosensitive layer assembly carried by said temporary support,
3) stripping off the temporary support to leave said continuous non-photosensitive layer assembly covering and adhering to said image-carrying permanent support, and
4) drying the resulting layer packet, wherein said continuous non-photosensitive layer assembly comprises the material of claim 1.

The present invention according to claim 1 thus also provides a material comprising a continuous non-photosensitive layer assembly carried by a temporary support, said material comprising the following layers in the given sequence on said temporary support :
- a polyester layer applied, e.g. laminated, to said temporary support and having a thickness of 5 to 30 µm,
- a subbing layer system comprising an optional primer coating e.g. of a copolyester and a subbing layer, and
- an adhesive top layer comprising gelatin and an adhesion-improving substance e.g. a polymer dispersion having a glass transition temperature lower than 0°C.

This process and material give satisfactory results for controlling gloss of an image obtained in a hydrophilic colloid layer or in superposed hydrophilic coloured colloid relief patterns obtained e.g. by wash-off processing of coloured image-wise hardened hydrophilic colloid layers.

The process offers easy handling and a short access time. Moreover, the resulting layer packet has a low curling tendency.

The temporary support of the continuous non-photosensitive layer assembly preferably is a polyolefin-coated paper support such as a polyethylene- or polypropylene-coated paper support.

The polyester layer preferably is a polyethylene terephthalate layer.

The subbing layer system consists of an optional primer coating, preferably comprising a copolyester of terephthalic acid, isophthalic acid, and sulfo-isophthalic acid and a subbing layer, preferably a layer comprising gelatin and cellulose nitrate.

The sticking power of the adhesive top layer to the pre-wet image-carrying permanent support can be improved substantially by adding dispersed polymer particles having a glass transition temperature (Tg) lower than 0°C, preferably lower than -10°C, as adhesion-improving substance to the gelatin of the adhesive top layer. Polymer particles containing an amount of monomer groups having a hydrophilic character e.g. free carboxylic acid groups as in copoly(vinyl acetate/acrylate ester/methacrylic acid) in which the content of methacrylic units is preferably in the range of 0.5 to 5 mol% and the Tg is -18°C, are preferred. An adhesion-improving substance of this type is sold under the registered trade mark DARATAK 74L by Grace Organic Chemical Division - Lexington, U.S.A. and is used in EP-A-462330. The adhesion-improving substance used according to the invention is polyethyl acrylate.

The colour tone of the image on the permanent support can be controlled by incorporating diffusion-resistant dyes or pigments in at least one layer of the continuous non-photosensitive layer assembly. For instance, a yellowish-brown tone of antique photographs or parchment base documents can be simulated thereby.

The transfer of the continuous non-photosensitive layer assembly from the temporary support is accomplished by pre-wetting the image-carrying permanent support with water, usually plain water, and pressing the continuous non-photosensitive layer assembly in dry state on the wet image-carrying permanent support. This can be done e.g. by feeding both materials through the nip of a roller pair exerting pressure on the contacting materials. After the transfer has been completed, the temporary support is peeled off e.g. by hand.

In the following example the composition and the use of a continuous non-photosensitive layer assembly is described.

### EXAMPLE

### Preparation of continuous non-photosensitive layer assembly

A temporary support consisting of a paper sheet having a weight of 100 g/m2 was coated by extrusion on one side with polyethylene to form a thin polyethylene layer thereon having a thickness of 30 µm. The hot polyethylene-coating was co-laminated with a polyethylene terephthalate film having a thickness of 12 µm.

A primer coating was applied to the polyethylene terephthalate layer by coating thereon a solution of copolyester of terephthalic acid, isophthalic acid, and sulfo-isophthalic acid (53/40/7% by weight) in ethanol at a ratio of 0.5 g/m2.

Next, a subbing layer was applied to the primer coating by coating thereon a composition containing the following ingredients :

| | |
|---|---|
| gelatin | 200 mg/m2 |
| cellulose nitrate | 125 mg/m2 |
| salicylic acid | 100 mg/m2 |

An adhesive top layer containing the following ingredients was then coated on the subbing layer (not according to the invention):

| | |
|---|---|
| gelatin | 2.0 g/m2 |
| DARATAK 74L as above identified | 1.4 g/m2 |
| matting agent A | 0.015 g/m2 |
| wetting agent W1 | 0.075 g/m2 |
| wetting agent W2 | 0.03 g/m2 |

- Matting agent A =: polymethyl methacrylate particles having an average particle size of 4 µm
- Wetting agent W1 =: saponin
- Wetting agent W2 =: disodium salt of heptadecyl-benzimidazole disulfonic acid

### Use of the continuous non-photosensitive layer assembly

A permanent support carrying a gelatin layer comprising a silver image (image-carrying permanent support) was wet with plain water and pressed in face-to-face contact with the dry adhesive top layer of the above continuous non-photosensitive layer assembly by conveying the contacting materials through the nip of a pair of pressure rollers.

After a contact time of 2 min in a hot airstream of 55°C the temporary support was stripped off, thus leaving the layer packet consisting of polyethylene terephthalate layer, subbing layer, and adhesive layer adhering tightly to the image-carrying permanent support.

The gloss of the resulting laminate (Invention) was measured by means of a gloss meter commercially available from Dr. LANGE, Type LMG 074 having a measuring angle of 20° and satisfying the standards ASTM D523, DIN 67530.

The gloss of the resulting laminate was compared with that measured on a same silver image-containing gelatin layer but that had not been covered with the gloss-improving layers (Comparison).

| Gloss results | |
|---|---|
| Invention | 55.6 |
| Comparison | 30.2 |

## Claims

1. A material comprising a continuous non-photosensitive layer assembly carried by a temporary support, wherein said material comprises the following layers in the given sequence on said temporary support :
- a polyester layer applied to said temporary support and having a thickness of 5 to 30 µm,
- a subbing layer system comprising an optional primer coating and a subbing layer, and
- an adhesive top layer comprising gelatin and poly(ethyl acrylate) as adhesion promoting substance.

2. A material according to claim 1 wherein said temporary support is a polyolefin-coated paper support.

3. A material according to claim 2, wherein said polyolefin-coated paper support is a polyethylene- or polypropylene-coated paper support.

4. A material according to any of claims 1 to 3, wherein said polyester layer is a polyethylene terephthalate layer.

5. A material according to any of claims 1 to 4, wherein said primer coating comprises a copolyester of terephthalic acid, isophthalic acid, and sulfo-isophthalic acid.

6. A material according to any of claims 1 to 5 wherein said subbing layer comprises gelatin and cellulose nitrate.

7. A process for controlling the visual aspect of an image present in a hydrophilic colloid layer, layer system, or relief pattern on a permanent support by transferring a continuous non-photosensitive layer assembly from a temporary support to said image, wherein said transfer is brought about by the consecutive steps of:
1) pre-wetting the image-carrying permanent support,
2) bringing the pre-wet image-carrying permanent support in face-to-face contact with said continuous non-photosensitive layer assembly carried by said temporary support,
3) stripping off the temporary support to leave said continuous non-photosensitive layer assembly covering and adhering to said image-carrying permanent support, and
4) drying the resulting layer packet,
characterized in that said continuous non-photosensitive layer assembly is a material as defined in any of the previous claims.

## Patentansprüche

1. Material mit einem von einem zeitweiligen Träger unterstützten, fortlaufenden, nicht strahlungsempfindlichen Schichtenverband, dadurch gekennzeichnet, dass das Material in der angegebenen Reihenfolge auf dem zeitweiligen Träger aufgebracht die nachstehenden Schichten enthält:
- eine auf den zeitweiligen Träger aufgetragene Polyesterschicht mit einer Stärke von 5 bis 30 µm,
- einen Haftschichtenverband, das eine eventuelle Grundierschicht und eine Haftschicht enthält, und
- eine klebende Deckschicht, die Gelatine und Poly(ethylacrylat) als Haftverstärker enthält.

2. Material nach Anspruch 1, dadurch gekennzeichnet, dass der zeitweilige Träger ein polyolefinbeschichteter Papierträger ist.

3. Material nach Anspruch 2, dadurch gekennzeichnet, dass der polyolefinbeschichtete Papierträger ein polyethylen- oder polypropylenbeschichteter Papierträger ist.

4. Material nach einem der Ansprüche 1 bis 3, dadurch gekennzeichnet, dass die Polyesterschicht eine Poly(ethylenterephthalat)-Schicht ist.

5. Material nach einem der Ansprüche 1 bis 4, dadurch gekennzeichnet, dass die Grundierschicht einen Copolyester aus Terephthalsäure, Isophthalsäure und Sulfoisophthalsäure enthält.

6. Material nach einem der Ansprüche 1 bis 5, dadurch gekennzeichnet, dass die Haftschicht Gelatine und Cellulosenitrat enthält.

7. Verfahren zur Kontrolle des visuellen Aussehens eines Bilds, das in einer hydrophilen Kolloidschicht, in einem Schichtenverband oder in einem Prägedruckmuster auf einem Dauerträger vorliegt, wobei ein fortlaufender, nicht strahlungsempfindlicher Schichtenverband von einem zeitweiligen Träger auf das Bild übertragen wird und die Übertragung in den untenstehenden aufeinanderfolgenden Verfahrensschritten erfolgt:
1) Vorbenetzen des Bild tragenden Dauerträgers,
2) schichtseitiges Zusammenbringen des vorbenetzten, Bild tragenden Dauerträgers und des von dem zeitweiligen Träger unterstützten fortlaufenden, nicht strahlungsempfindlichen Schichtenverbands,
3) Abziehen des zeitweiligen Trägers, so dass der fortlaufende, nicht strahlungsempfindliche Schichtenverband den Bild tragenden Dauerträger bedeckt und daran haftet, und
4) Trocknen des erhaltenen Schichtenpakets,
dadurch gekennzeichnet, dass der fortlaufende, nicht strahlungsempfindliche Schichtenverband ein Material nach einem der vorstehenden Ansprüche ist.

## Revendications

1. Matériau comprenant un ensemble de couches continues non photosensibles supporté par un support temporaire, caractérisé en ce que ledit matériau comprend les couches suivantes dans l'ordre indiqué sur ledit support temporaire :
- une couche de polyester appliquée sur ledit support temporaire et présentant une épaisseur de 5 à 30 µm,
- un système de sous-couches comprenant une couche de fond éventuelle et une sous-couche, et
- une couche superficielle adhésive contenant de la gélatine et du poly(acrylate d'éthyle) en tant que promoteur d'adhésion.

2. Matériau selon la revendication 1, caractérisé en ce que ledit support temporaire est un support en papier enduit de polyoléfine.

3. Matériau selon la revendication 2, caractérisé en ce que ledit support en papier enduit de polyoléfine est un support en papier enduit de polyéthylène ou de polypropylène.

4. Matériau selon l'une quelconque des revendications 1 à 3, caractérisé en ce que ladite couche de polyester est une couche de poly(téréphtalate d'éthylène).

5. Matériau selon l'une quelconque des revendications 1 à 4, caractérisé en ce que ladite couche de fond contient un copolyester de l'acide téréphtalique, de l'acide isophtalique et de l'acide sulfoïsophtalique.

6. Matériau selon l'une quelconque des revendications 1 à 5, caractérisé en ce que ladite sous-couche contient de la gélatine et du nitrate de cellulose.

7. Procédé de contrôle de l'aspect visuel d'une image contenue dans une couche colloïdale hydrophile, dans un système de couches, ou dans un motif en relief sur un support durable par le transfert d'un ensemble de couches continues non photosensibles à partir d'un support temporaire sur ladite image, caractérisé en ce que ledit transfert se produit par les étapes successives consistant à :
1) prémouiller le support durable supportant l'image,
2) mettre le support durable prémouillé supportant l'image et ledit ensemble de couches continues non photosensibles supporté par ledit support temporaire en contact face à face,
3) pelliculer le support temporaire de manière que ledit ensemble de couches continues non photosensibles recouvre ledit support durable supportant l'image et y adhère, et
4) sécher le paquet de couches ainsi obtenu,
caractérisé en ce que ledit ensemble de couches continues non photosensibles est un matériau tel que défini dans l'une quelconque des revendications précédentes.
